# FASCICULE DE BREVET EUROPEEN

(11) **EP 1 163 637 B1**
(45) Date de publication et mention de la délivrance du brevet: **04.06.2003**
(21) Numéro de dépôt: 00909436.8
(22) Date de dépôt: 06.03.2000
(51) Int. Cl.: G06K 19/077

(54) **PROCEDE DE FABRICATION POUR DISPOSITIF ELECTRONIQUE DU TYPE CARTE SANS CONTACT**
VERFAHREN ZUR HERSTELLUNG EINER ELEKTRONISCHEN VORRICHTUNG DER KONTAKTLOSEN KARTEN ART
METHOD FOR MAKING AN ELECTRONIC DEVICE SUCH AS A CONTACTLESS CARD

(30) Priorité: 12.03.1999 FR 9903102
(43) Date de publication de la demande: 19.12.2001
(73) Titulaire: Gemplus, 13881 Gémenos Cedex (FR)
(72) Inventeur: PATRICE, P., Résidence les deux Moulins, F-13190 Allauch (FR); ZAFRANY, Michael, F-13006 Marseille (FR)
(86) Numéro de dépôt international: FR0000555
(87) Numéro de publication internationale: WO00055808

(56) Documents cités:
- WO-A-98/06063
- FR-A- 2 756 955
- US-A- 4 931 853
- US-A- 5 528 222
- US-A- 5 826 328

## Description

L'invention concerne la fabrication de dispositifs électroniques, par exemple des dispositifs portables tels que des cartes à puce sans contact, ou encore des étiquettes électroniques ou des modules électroniques comportant une antenne.

De telles cartes sont destinées à réaliser diverses opérations telles que bancaires, téléphoniques, d'identification, de débit ou de rechargement d'unité de compte.

Les étiquettes et les modules électroniques permettent toute sorte d'opérations d'identification.

Un des problèmes de tels dispositifs est la connexion de l'antenne à la puce de circuit intégré.

Un autre problème dans le cas d'une carte ou étiquette, est la réduction au maximum de l'épaisseur.

Les contraintes classiques de tenue mécanique, de fiabilité et de coût de fabrication doivent évidemment être prises en compte.

Le document WO 96/07985, réalise la connexion entre l'antenne et la puce avec des bossages métalliques sur deux plots de contact de la puce, puis connecte ces bossages sur les extrémités d'un fil d'antenne. Dans ce cas, le fil d'antenne est un fil de cuivre formé sur un substrat et les bossages sont appliqués sur ce fil d'antenne par compression à chaud.

Cependant, le bloc d'interconnexion ainsi obtenu présente des problèmes de tenue mécanique et de fragilité en traction de la connexion. En effet, les sollicitations mécaniques peuvent entraîner la rupture des bossages et l'arrachage de la puce. Les cartes réalisées selon ce procédé ont une durée de vie courte.

Dans une autre solution est en la connexion colle conductrice. Cependant, une surépaisseur apparaît. De plus, la fabrication de la carte nécessite une étape supplémentaire de distribution de points de colle.

Afin de réaliser une carte à puce sans contact ultra plate, l'épaisseur est inférieure à l'épaisseur normalisée ISO de 0.76 mm.

De plus, l'utilisation de colle conductrice peut, dans certains cas, entraîner des dysfonctionnements électriques en cas de coulée de la colle sur les flancs de la puce.

Le document US-A-4931853 (Toshiba) décrit une carte à puce avec une feuille de coeur en thermoplastique et une puce qui possède des saillies d'électrodes. Ces saillies sont disposées à fleur de la feuille, et par chauffage ils subissent une déformation plastique.

Le document US-A-5528222 (IBM) décrit une étiquette électronique fine et flexible, dont les connexions d'antenne sont toutes dans le même plan. Des bossages sont reliés à l'antenne à travers une fenêtre qui débouche de part et d'autre d'un substrat.

Le document US-A-5826328 (IBM) décrit une étiquette électronique fine et flexible. La puce est directement attachée et reliée au cadre de l'antenne. Un assemblage par laminage d'une bande du cadre d'antenne à des puces liées par apport de pression et de chaleur ou par laminage à 200°C entre des rouleaux.

Le document WO-A-9806063 (Solaic) décrit un module hybride, relié à une antenne par divers moyens de perforation tels que des vis.

Le document FR-A-2756955 (Schlumberger) décrit une carte à mémoire sans contact, avec des protubérances sur la pastille qui est montée de préférence avec une colle conductrice plutôt que par thermo compression.

Le but de l'invention est de pallier ces inconvénients.

A cet effet, l'invention est définie dans les revendications.

Etant donné que les bossages sont incrustés dans l'épaisseur de l'antenne, l'ensemble d'interconnexion formé par la puce et l'antenne présente un encombrement réduit, ce qui est très avantageux pour réaliser un module électronique ultra plat.

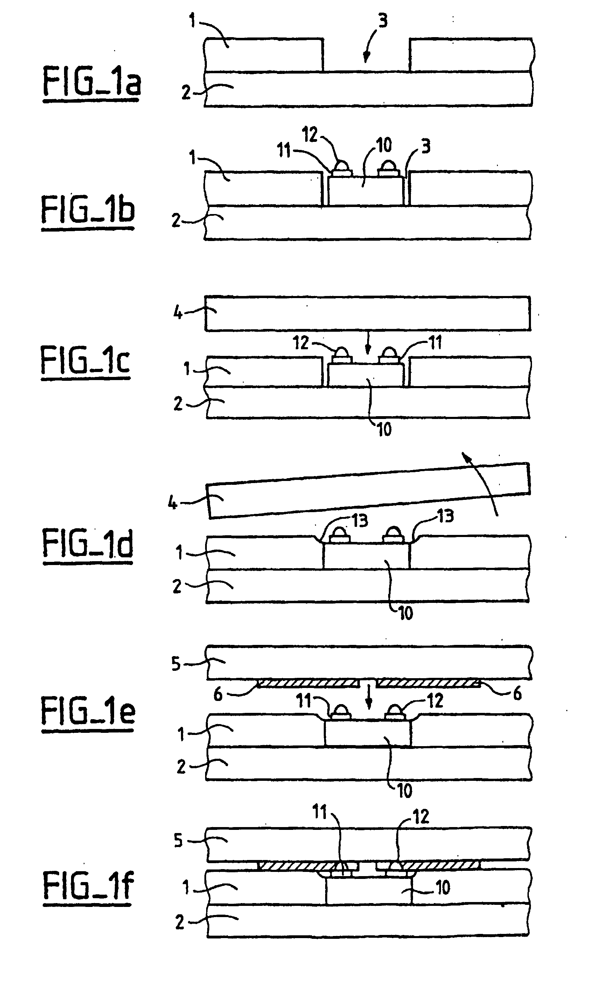

D'autres particularités et avantages de l'invention apparaîtront à la lecture de la description d'exemples en référence aux figures 1a à 1f annexées qui représentent schématiquement les étapes de fabrication d'un dispositif électronique sans contact selon l'invention.

Les figures la à if illustrent les étapes de connexion entre une puce 10 et une antenne 6. L'ensemble d'interconnexion formé par la puce 10 et l'antenne 6 est destiné à être inséré dans une carte à puce sans contact d'épaisseur ultra fine et inférieure à l'épaisseur normalisée ISO, ou dans tout autre dispositif électronique comportant une antenne.

Pour des raisons de clarté, les figures et la description qui suivent se référent à une puce et une antenne. Cependant, la présente invention s'applique également à un procédé de fabrication d'un circuit encarté sans contact comportant une pluralité de puces et une pluralité d'antennes.

En se référant à la figure la, une empreinte 3 est réalisée dans un support isolant 1, de dimension légèrement plus grande que la taille d'une puce.

Le substrat isolant 1 peut être constitué, par exemple, de feuilles plastiques en polychlorure de vinyle (PVC) ou en polyéthylène (PE).

Selon les modes de réalisation, cette empreinte 3 peut être usinée dans le support isolant i ou créée par collage ou par lamination de deux feuilles 1 et 2 isolantes l'une sur l'autre, la feuille 1 étant trouée par une empreinte 3. Ces feuilles 1 et 2 sont préférentiellement découpées au format de la carte ou du circuit que l'on veut réaliser.

La figure 1b illustre le report d'une puce 10 dans l'empreinte 3 de la feuille 1. Ce report est effectué, face active vers le haut, selon une quelconque technique connue. Les contacts 11 de la puce 10 affleurent la surface de la feuille isolante 1.

Une étape préliminaire du procédé de fabrication selon l'invention consiste à former des bossages métallisés 12 sur des plots de contact 11 de la puce 10. Les bossages 12 sont destinés à assurer la connexion électrique entre la puce 10 et l'antenne 6. Ils sont par conséquent nécessairement réalisés dans un matériau conducteur. Ils peuvent par exemple être réalisés en or, ou alors dans un matériau polymère chargé en particules métalliques.

De préférence les bossages 12 sont réalisés sur les deux plots de contact 11 de la puce 10 afin de pouvoir réaliser une connexion sur des plages conductrices de l'antenne 6 situées à ses extrémités.

Étant donné que les bossages 12 sont destinés à s'incruster dans l'épaisseur de l'antenne 6, ils présentent de préférence une épaisseur environ égale, ou légèrement inférieure, à celle de l'antenne. De plus, pour permettre une bonne pénétration des bossages 12 dans l'épaisseur de l'antenne 6, on leur préfère une forme sensiblement conique.

Dans l'hypothèse où la tranche de la puce 10 est conductrice, il est avantageux de procéder à une isolation de ses flancs. Cette étape n'est pas nécessaire lorsqu'on a recours à un type de puce 10 dont les tranches ne sont pas conductrices par nature, et sont par conséquent déjà isolées.

Les figures 1c et 1d illustrent un mode de réalisation particulier de l'isolation des flancs de la puce 10.

Selon ce mode de réalisation, une feuille 4 est laminée à chaud sur l'ensemble feuilles isolantes-puce. Cette feuille 4 est avantageusement de nature à ne pas adhérer sur les feuilles isolantes 1 et 2 définissant l'empreinte 3.

Il peut être envisagé d'utiliser un tapis de lamination à la place de la feuille 4.

Selon une particularité de l'invention, la lamination à chaud sur l'ensemble feuilles isolantes-puce, réalisée par un tapis ou par une feuille 4, permet de favoriser l'étalement du matériau partiellement fondu de la feuille isolante 1 de manière à isoler les tranches de la puce 10. En effet, une coulée 13 du matériaude la feuille 1 permet de boucher l'intervalle laissé entre la puce 10 et l'empreinte 3 légèrement plus grande que cette dernière.

La puce 10 est ainsi incrustée dans un substrat isolant constitué par les deux feuilles 1 et 2, avec les plots de contact 11 et ses bossages 12 affleurant la surface de la feuille 1.

Selon une variante de réalisation, on peut réaliser l'isolation des flancs de la puce 10 par distribution ou par pulvérisation d'un matériau isolant remplissant l'intervalle entre les bords de l'empreinte 3 et les flancs de la puce 10.

En se référant à la figure le, une antenne 6 est réalisée sur un support isolant 5.

Le support isolant 5 est par exemple constitué par une feuille plastique au format de la carte à puce ou du circuit à réaliser. Il peut par exemple être composé de polychlorure de vinyle (PVC) ou de polyéthylène (PE).

L'antenne 6 est réalisée dans un matériau conducteur apte à être ramolli au moment de sa connexion avec la puce 10, afin de permettre une meilleure pénétration des bossages 12. Sa forme importe peu, elle peut par exemple représenter une spirale ou tout autre motif.

Un premier mode de réalisation consiste à réaliser l'antenne 6 dans un matériau thermoplastique chargé en particules métalliques. L'antenne est formée dans ce cas par sérigraphie d'encre conductrice à base thermoplastique. Les particules métalliques sont par exemple constituées par des petites billes d'argent.

La feuille 5 est laminée à chaud sur les feuilles 1 et 2. L'apport de chaleur permet de ramollir le matériau thermoplastique constituant l'antenne 6, et la lamination facilite la pénétration des bossages 12 dans l'épaisseur de l'antenne en vue de réaliser la connexion de la puce 10 à l'antenne 6. Lorsque l'opération de lamination est terminée, on laisse l'ensemble d'interconnexion obtenu refroidir à l'air ambiant afin de permettre au matériau de l'antenne de retrouver son état solide et sa forme initiale. L'antenne thermoplastique présente généralement des propriétés adhésives au cours de son ramollissement qui permettent de fixer la puce.

Dans une variante de réalisation, l'antenne 6 est réalisée dans un matériau polymère thermodurcissable conducteur, c'est à dire chargé de particules métalliques. Dans ce cas, on fait en sorte de ne pas polymériser le matériau d'antenne avant l'étape de connexion de la puce avec l'antenne, de manière à ce que ce matériau se présente dans un état visqueux.

La lamination à chaud permet alors d'une part de faciliter la pénétration des bossages 12 dans l'épaisseur du matériau de l'antenne 6, et d'autre part de polymériser le matériau thermodurcissable constituant l'antenne 6 afin de le durcir.

La figure if illustre l'ensemble d'interconnexion obtenu par le procédé selon la présente invention.

Grâce au procédé de fabrication selon l'invention, il est possible de fabriquer des dispositifs électroniques tels que des étiquettes ou des cartes à puce sans contact d'épaisseur ultra fine. L'épaisseur du dispositif obtenu est en effet égale à la somme des épaisseurs des trois feuilles plastiques 1, 2 et 5, et de l'antenne 6, la puce 10 étant incrustée dans la feuille 1, et les bossages 12 étant incrustés dans l'épaisseur de l'antenne 6.

De plus, les bossages 12 étant complètement incrustés dans l'épaisseur de l'antenne 6, ils ne risquent pas d'être détériorés par des sollicitations mécaniques. L'ensemble d'interconnexion obtenu présente donc une très bonne tenue mécanique et une durée de vie. accrue.

En outre, il est possible, en utilisant le procédé de la présente invention, de ne pas travailler uniquement au format d'une carte, mais à un format plus grand et de découper ensuite une pluralité de cartes.

Il est ainsi possible, en une seule opération, de connecter une matrices de puces à une matrice d'antennes et de réaliser leur encartage.

Le procédé selon l'invention, réalisé à partir de grandes feuilles isolantes 1, 2, 5, permet un positionnement précis des feuilles les unes par rapport aux autres, et donc un positionnement précis des plots de contact des puces par rapport aux plots de connexion des antennes.

## Revendications

1. Procédé de fabrication d'un dispositif électronique comportant au moins une puce de circuit intégré (10) reliée . à une antenne (6), le procédé comporte les étapes suivantes :
- report de ladite puce (10) dans une empreinte (3) ménagée dans Un support en matériau isolant (1), les plots de connexion de ladite puce (10) portant des bossages (12);
- connexion de ladite puce (10) à ladite antenne (6) par lamination à chaud d'une feuille isolante (5) portant ladite antenne (6), **caractérisé en ce que** lesdits bossages étant incrustés dans l'épaisseur de plots de connexion de ladite antenne (6) pendant ladite lamination à chaud.

2. Procédé de fabrication selon la revendication 1, **caractérisé en ce que** l'empreinte (3) est constituée par une feuille isolante (1) perforée, laminée ou collée sur une deuxième feuille, isolante (2), la perforation présentant des dimensions supérieures à celles de la puce (10).

3. Procédé de fabrication selon la revendication 1, **caractérisé en ce que** l'empreinte (3) est réalisée par usinage dans le matériau isolant (1).

4. Procédé de fabrication selon l'une des revendications 1 à 3, **caractérisé en ce qu'**il comporte en outre une étape d'isolation (13) des flancs de la puce (10).

5. Procédé de fabrication selon la revendication 4, **caractérisé en ce que** l'isolation (13) des flancs de la puce (10) est réalisée par distribution d'un matériau isolant remplissant l'intervalle entre les bords de l'empreinte (3) et les flancs de la puce (10).

6. Procédé de fabrication selon la revendication 4, **caractérisé en ce que** l'isolation (13) des flancs de la puce (10) est réalisée par pulvérisation d'un matériau isolant remplissant l'intervalle entre les bords de l'empreinte (3) et les flancs de la puce (10).

7. Procédé de fabrication selon la revendication 4, **caractérisé en ce que** l'isolation (13) des flancs de la puce (10) est réalisée par lamination à chaud du matériau du support isolant (1) de manière à former une coulée dans l'intervalle entre les bords de l'empreinte (3) et les flancs de la puce (10) .

8. Procédé de fabrication selon 1es revendications 4 et 7, **caractérisé en ce que** l'étape d'isolation des flancs de la puce (10) et l'étape de connexion de la puce (10) à l'antenne (6) sont réalisées au cours d'une seule lamination.

9. Procédé de fabrication selon l'une quelconque des revendications précédentes, **caractérisé en ce que** la puce (10) comporte des bossages métalliques (12) réalisés sur chaque plots de. connexion (11), l'antenne (6) étant réalisée dans un matériau apte à être ramolli par thermocompression.

10. Procédé de fabrication selon la revendication 8, **caractérisé en ce que** les bossages métallisés (12) présentent une forme sensiblement conique.

11. Procédé, de fabrication selon l'une quelconque des revendications précédentes, **caractérisé en ce que** les feuilles isolantes (1, 2, 5) présentent des dimensions supérieures ou égales au format du dispositif électronique à réaliser, les feuilles isolantes (1, 2, 5) étant découpées, après l'étape de connexion d'une pluralité de puces (10) à une pluralité antennes (6), pour dégager une pluralité de dispositifs électroniques.

12. Procédé de fabrication selon l'une des quelconques des revendications 1 à 9, **caractérise en ce que** les feuilles isolantes (1, 2, 5) présentent des dimensions égales au format du dispositif électronique à réaliser, une puce (10) étant connectée à une antenne (6).

13. Procédé de fabrication selon l'une des revendications 10 et 11, **caractérisé en ce que** le dispositif électronique à réaliser est une carte à puce.

14. Procédé de fabrication selon l'une des revendications 10 et 11, **caractérisé en ce que** le dispositif électronique à réaliser est une étiquette électronique.

15. Carte à puce comprenant une antenne (6), ladite puce (10) étant logée dans une empreinte (3) ménagée dans un support en matériau isolant (1), ladite puce (10) comprenant des plots de connexion connectés électriquement à des plots de connexion de ladite antenne, ladite connexion électrique est constituée par des bossages portés par lesdits plots de connexion de ladite puce (10), **caractérisée en ce que** lesdits bossages étant incrustés dans l'épaisseur desdits plots de connexion de ladite antenne (6) , ladite antenne étant portée par une feuille isolante rapportée sur ladite puce.

16. Etiquette électronique comprenant une puce (10) logée dans une empreinte (3) ménagée dans un support en matériau isolant (1), ladite puce (10) comprenant des plots de connexion connectés électriquement à des plots de connexion d'une antenne, ladite connexion électrique est constituée par des bossages portés par lesdits plots de connexion de ladite puce (10), **caractérisée en ce que** lesdits bossages étant incrustés dans l'épaisseur desdits plots de connexion de ladite antenne (6), ladite antenne étant portée par une feuille isolante rapportée sur ladite puce.

## Claims

1. A method for manufacturing an electronic device comprising at least one integrated circuit chip (10) connected to an antenna (6), the method including the following steps:
- attaching the said chip (10) in a recess (3) provided in a support made from insulating material (1), the connection pads on the said chip (10) carrying bumps (12);
- connecting the said chip (10) to the said antenna (6) by hot lamination of an insulating sheet (5) carrying the said antenna (6), **characterised in that** the said bumps are embedded in the thickness of the connecting pads of the said antenna (6) during the said hot lamination.

2. A manufacturing method according to Claim 1, **characterised in that** the recess (3) is formed by a perforated insulating sheet (1), laminated or bonded to a second insulating sheet (2), the perforation having dimensions greater than those of the chip (10).

3. ,A manufacturing method according to Claim 1, **characterised in that** the recess (3) is produced by machining in the insulating material (1).

4. A manufacturing method according to one of Claims 1 to 3, **characterised in that** it also includes a step (13) of insulating the edges of the chip (10).

5. A manufacturing method according to Claim 4, **characterised in that** the insulation (13) of the edges of the chip (10) is effected by distributing an insulating material filling in the gap between the edges of the recess (3) and the edges of the chip (10).

6. A manufacturing method according to Claim 4, **characterised in that** the insulation (13) of the edges of the chip (10) is carried out by spraying an insulating material filling in the gap between the edges of the recess (3) and the edges of the chip (10).

7. A manufacturing method according to Claim 4, **characterised in that** the insulation (13) of the edges of the chip (10) is carried out by hot lamination of the material of the insulating support (1) so as to form a casting in the gap between the edges of the recess (3) and the edges of the chip (10).

8. A manufacturing method according to Claims 4 and 7, **characterised in that** the step of insulating the edges of the chip (10) and the step of connecting the chip (10) to the antenna (6) are performed during a single lamination.

9. A manufacturing method according to any one of the preceding claims, **characterised in that** the chip (10) has metallic bumps (12) produced on each connecting pad (11), the antenna (6) being produced from a material able to soften by thermocompression.

10. A manufacturing method according to Claim 8, **characterised in that** the metallised bumps (12) have a substantially conical shape.

11. A manufacturing method according to any one of the preceding claims, **characterised in that** the insulating sheets (1, 2, 5) have dimensions greater than or equal to the format of the electronic device to be produced, the insulating sheets (1, 2, 5) being cut out, after the step of connecting a plurality of chips (10) to a plurality of antennae (6), in order to release a plurality of electronic devices.

12. A manufacturing method according to any one of Claims 1 to 9, **characterised in that** the insulating sheets (1, 2, 5) have dimensions equal to the format of the electronic device to be produced, a chip (10) being connected to an antenna (6).

13. A manufacturing method according to one of Claims 10 and 11, **characterised in that** the electronic device to be produced is a smart card.

14. A manufacturing method according to one of Claims 10 and 11, **characterised in that** the electronic device to be produced is an electronic label.

15. A smart card comprising an antenna (6), the said chip (10) being housed in a recess (3) provided in a support made from insulating material (1), the said chip (10) comprising connection pads electrically connected to connection pads on the said antenna, the said electrical connection consisting of bumps carried by the said connection pads on the said chip (10), **characterised in that** the said bumps are embedded in the thickness of the said connecting pads of the said antenna (6), the said antenna being carried by an insulating sheet attached to the said chip.

16. An electronic label comprising a chip (10) housed in a recess (3) provided in a support made from insulating material (1), the said chip (10) comprising connection pads electrically connected to connection pads on an antenna, the said electrical connection consisting of bumps carried by the said connection pads on the said chip (10), **characterised in that** the said bumps are embedded in the thickness of the said connection pads of the said antenna (6), the said antenna being carried by an insulating sheet attached to the said chip.

## Patentansprüche

1. Herstellungsverfahren einer elektronischen Vorrichtung, umfassend wenigstens einen an eine Antenne (6) angeschlossenen integrierten Schaltkreis-Chip (10), das Verfahren beinhaltet folgende Schritte:
- Übertrag des besagten Chips (10) in eine in einem Träger aus Isolationsmaterial (1) ausgesparte Vertiefung (3), wobei die Verbindungssteckstellen des besagten Chips (10) Buckel (12) tragen;
- Verbindung des besagten Chips (10) mit der besagten Antenne (6) durch Heißwalzen einer die besagte Antenne (6) tragenden Isolierfolie (5), **dadurch gekennzeichnet, dass** die besagten Buckel während des besagten Heißwalzens in die Stärke der Verbindungssteckstellen der besagten Antenne (6) eingesetzt werden.

2. Herstellungsverfahren gemäß Anspruch 1, **dadurch gekennzeichnet, dass** die Vertiefung (3) durch eine auf eine zweite Isolierfolie (2) gewalzte oder geklebte perforierte Isolierfolie (1) gebildet wird, wobei die Perforation größere Abmessungen als die des Chips (10) aufweist.

3. Herstellungsverfahren gemäß Anspruch 1, **dadurch gekennzeichnet, dass** die Vertiefung (3) durch Verarbeitung im Isoliermaterial (1) realisiert wird.

4. Herstellungsverfahren gemäß Anspruch 1 bis 3, **dadurch gekennzeichnet, dass** es darüber hinaus einen Isolierschritt (13) der Seiten des Chips (10) umfasst.

5. Herstellungsverfahren gemäß Anspruch 4, **dadurch gekennzeichnet, dass** die Isolation (13) der Seiten des Chips (10) durch Einbringen eines den Zwischenraum zwischen den Rändern der Vertiefung (3) und den Seiten des Chips (10) ausfüllenden Isoliermaterials (1) realisiert wird.

6. Herstellungsverfahren gemäß Anspruch 4, **dadurch gekennzeichnet, dass** die Isolation (13) der Seiten des Chips (10) durch Aufsprühen eines den Zwischenraum zwischen den Rändern der Vertiefung (3) und den Seiten des Chips (10) ausfüllenden Isoliermaterials realisiert wird.

7. Herstellungsverfahren gemäß Anspruch 4, **dadurch gekennzeichnet, dass** die Isolation (13) der Seiten des Chips (10) durch Heißwalzen des isolierenden Trägermaterials (1) derart realisiert wird, dass ein Erguss im Zwischenraum zwischen den Rändern der Vertiefung (3) und den Seiten des Chips (10) gebildet wird.

8. Herstellungsverfahren gemäß Anspruch 4 bis 7, **dadurch gekennzeichnet, dass** der Isolierschritt der Seiten des Chips (10) und der Verbindungsschritt des Chips (10) mit der Antenne (6) während einer einzigen Walzung realisiert werden.

9. Herstellungsverfahren gemäß einem der vorherigen Ansprüche, **dadurch gekennzeichnet, dass** der Chip (10) auf jeder Verbindungssteckstelle (11) realisierte Metallbuckel (12) umfasst, wobei die Antenne (6) aus einem Material realisiert ist, das geeignet ist, durch Thermokompression aufgeweicht zu werden.

10. Herstellungsverfahren gemäß Anspruch 8, **dadurch gekennzeichnet, dass** die Metallbuckel (12) eine deutlich konische Form aufweisen.

11. Herstellungsverfahren gemäß einem der vorherigen Ansprüche, **dadurch gekennzeichnet, dass** die Isolierfolien (1, 2, 5) größere oder gleiche Abmessungen wie das Format der zu realisierenden elektronischen Vorrichtung aufweisen, wobei die Isolierfolien (1, 2, 5) nach dem Verbindungsschritt einer Vielzahl von Chips (10) mit einer Vielzahl von Antennen (6) ausgeschnitten werden, um eine Vielzahl von elektronischen Vorrichtungen freizulegen.

12. Herstellungsverfahren gemäß Anspruch 1 bis 9, **dadurch gekennzeichnet, dass** die Isolierfolien (1, 2, 5) gleiche Abmessungen wie das Format der zu realisierenden elektronischen Vorrichtung aufweisen, wobei ein Chip (10) an eine Antenne (6) angeschlossen ist.

13. Herstellungsverfahren gemäß Anspruch 10 und 11, **dadurch gekennzeichnet, dass** die zu realisierende elektronische Vorrichtung eine Chipkarte ist.

14. Herstellungsverfahren gemäß Anspruch 10 und 11, **dadurch gekennzeichnet, dass** die zu realisierende elektronische Vorrichtung ein elektronisches Etikett ist.

15. Chipkarte, umfassend eine Antenne (6), wobei der besagte Chip (10) in einer in einem Träger aus Isoliermaterial (1) ausgesparten Vertiefung (3) untergebracht ist, wobei der besagte Chip (10) elektrisch an Verbindungssteckstellen der besagten Antenne angeschlossene Verbindungssteckstellen umfasst, die besagte elektrische Verbindung wird durch die von den besagten Verbindungssteckstellen des besagten Chips (10) getragenen Buckel gebildet, **dadurch gekennzeichnet, dass** die besagten Buckel in die Stärke der besagten Verbindungssteckstellen der besagten Antenne (6) eingesetzt sind, wobei die besagte Antenne (6) durch eine auf den besagten Chip aufgesetzte Isolierfolie getragen wird.

16. Elektronisches Etikett, umfassend einen in einer in einem Träger aus Isoliermaterial (1) ausgesparten Vertiefung (3) untergebrachten Chip (10), wobei der besagte Chip (10) elektrisch mit den Verbindungssteckstellen einer Antenne verbundenen Verbindungssteckstellen umfasst, die elektrische Verbindung wird durch von den besagten Verbindungssteckstellen des besagten Chips (10) getragenen Buckel gebildet, **dadurch gekennzeichnet, dass** die besagten Buckel in die Stärke der besagten Verbindungssteckstellen der besagten Antenne (6) eingesetzt sind, wobei die besagte Antenne durch eine auf den besagten Chip aufgesetzte Isolierfolie getragen wird.
